**Europäisches Patentamt**

**European Patent Office**

**Office européen des brevets**

(11) Veröffentlichungsnummer: **0 216 174**

**A1**

# (12) EUROPÄISCHE PATENTANMELDUNG

(21) Anmeldenummer: 86111805.7

(22) Anmeldetag: 26.08.86

(51) Int. Cl.4: **G02B 6/34** , **H01L 31/02**

(30) Priorität: 25.09.85 DE 3534196
07.02.86 DE 3603932

(43) Veröffentlichungstag der Anmeldung:
01.04.87 Patentblatt 87/14

(84) Benannte Vertragsstaaten:
AT BE CH DE FR GB IT LI NL SE

(71) Anmelder: **Siemens Aktiengesellschaft Berlin und München**
**Wittelsbacherplatz 2**
**D-8000 München 2(DE)**

(72) Erfinder: **Frenkel, Ferdinand, Dr. Dipl.-Phys.**
**Elisenstrasse 10**
**D-8900 Augsburg(DE)**
Erfinder: **Haberland, Detlef, Dr.Dipl.-Phys.**
**Fichtenstrasse 14**
**D-8031 Steinebach(DE)**
Erfinder: **Haltenorth, Helmut, Dr. Dipl.-Ing.**
**Werner- Friedmann-Bogen 18**
**D-8000 München 50(DE)**
Erfinder: **Prussas, Herbert, Dipl.-Ing.**
**Mozartring 11**
**D-8069 Reichertshausen(DE)**

(54) Lichtweichen-Einheit.

(57) Für ein optoelektronisches Kommunikationssystem dienende lichtdicht gekapselte Lichtweichen(2)-Einheit(1, 2), deren Kapsel(1) drei Informationsanschlüsse(11, 12, 13) aufweist und einen massiven Block(2) mit dessen drei Lichtanschlüssen(3, 4, 5), die jeweils mit einem der Informationsanschlüsse(11, 12, 13) verbunden sind, umschließt. Zwischen den Lichtanschlüssen (3, 4, 5) ist in den Block(2) mindestens eine Glasfaser(9)-Lichtleitung eingebettet. Der zweite und/oder der dritte Lichtanschluß(3,4) wird durch ein ebenes Glasfaserende gebildet, das in derselben Ebene wie nahe Bereiche der Blockoberfläche liegt, wobei solche Glasfaserenden(3, 4) nicht aus dem Block(2) hervorstehen. In mindestens eine Glasfaser(9) ist ein Lichtwellenlängenfilter(10) eingefügt, wodurch der Block(2) die Lichtweiche (2) darstellt: der erste Lichtanschluß(5) wird bidirektional, der zweite und der dritte unidirektional betrieben; das dem ersten Lichtanschluß(5) zugeleitete Licht eines ersten Lichtwellenlängenbereiches wird im wesentlichen zum zweiten Lichtanschluß(4) weitergeleitet; das dem dritten Lichtanschluß(3) zugeleitete Licht eines zweiten Lichtwellenlängenbereiches im wesentlichen zum ersten Lichtanschluß (5). Innerhalb der leitenden, abschirmenden Kapsel(1) ist am zweiten Lichtanschluß (4) ein Lichtempfangs-Halbleiterbaukörper(7) sowie am dritten Lichtanschluß(3) ein Lichtsende-Halbleiterbaukörper(6) ohne zusätzlicher Glasfaser befestigt. Die mit den Halbleiterbaukörpern(6, 7) verbundenen Informationsanschlüsse(11, 12) bilden elektrische, aber der erste, mit dem ersten Lichtanschluß(5) verbundene Informationsanschluß(13) einen optischen Anschluß. Die Kapsel(1) dient, in der Nähe von weiteren Hochfrequenzschaltungen, als hochfrequenz-abgeschirmte Schnittstelle zwischen einerseits einer außen angebrachten Glasfaser-Lichtleitung, die an den ersten Informationsanschluß(13) angeschlossen ist, und andererseits elektronischen Hochfrequenz-Schaltungsanordnungen, die an die anderen Informationsanschlüsse(11, 12) angeschlossen sind.

# FIG 1

## Lichtweichen-Einheit

Die Erfindung betrifft einen speziellen optoelektronischen, für Multiplex-Demultiplex-Betrieb geeigneten Baustein eines Kommunikationssystems, nämlich die im Oberbegriff des Patentanspruches 1 definierte besondere Lichtweichen-Einheit, welche für sich z.B. durch

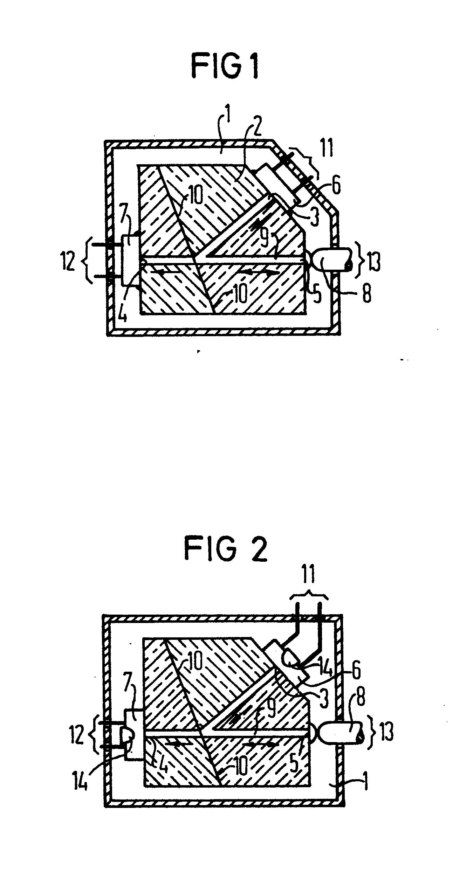

-DE-PS 29 21 035, vor allem Fig. 2;

-Miyauchi et al., in Opt.Lett. 5 (Juli 1980) No. 7, S. 321 bis 322 (521 bis 522?);

-ntz-Archiv 5 (1983) S. 97 bis 99, vor allem Fig. 1 und 2;

-J. of Lightwave Techn., LT-2, No. 4 (Aug. 1984), S. 369 bis 378, vor allem Fig. 1(a) und 6; sowie

-J. of Lightwave Techn., LT-2, No. 5 (Okt. 1984), S. 675 bis 681

vorbekannt ist.

Alle diese vorbekannten Lichtweichen-Einheiten weisen jeweils eine Kapsel mit rein optischen Informationsanschlüssen auf. Bei diesen vorbekannten Lichtweichen-Einheiten sind nämlich die Informationsanschlüsse der Kapsel jeweils Glasfaseranschlüsse, indem dort Licht als Informationenträger im Verbindungsweg des Kommunikationssystems bis zu den peripheren Teilnehmerstationen benützt wird. Ein solcher Betrieb eines Verbindungsweges ist aber oft gar nicht günstig: er benötigt einen oft zu hohen feinmechanischen und optisch-präzisen Aufwand besonders hinsichtlich der vielen Glasfaser-Lichtleitungsanschlüsse, u.zw. nicht nur an den Informationsanschlüssen der vielen Lichtweichen-Einheiten, sondern auch besonders in den -in einem solchen Kommunikationssystem, besonders in einem öffentlichen Vermittlungssystem, meistens äußerst zahlreichen - Leitungsabschnitten zwischen den Lichtweichen-Einheiten und den oft vielen Tausenden von Teilnehmerstationen. Die Erfindung soll diesen Aufwand für viele Fälle stark spürbar zu verringern gestatten.

Durch die

-DE-PS 28 40 602, vor allem Fig. 1 und 2, ist eine Lichtweichen-Einheit mit einer langen, röhrenförmigen Metallhülse als Kapsel vorbekannt. Dort sind noch immer neben einem elektrischen noch zwei rein optische Informationsanschlüsse angebracht. In der Wandung der Kapsel ist ein Lichtempfangs-Halbleiterbaukörper für den elektrischen Informationsanschluß angebracht, wobei dieser Halbleitertbaukörper nicht mehr durch die Kapsel gegen Hochfrequenzschwingungen abgeschirmt ist.

Durch die

-ntz 31 (Febr. 1978) Nr. 2, S. 144 bis 146 ist eine Meßanordnung mit Lichtweichen-Einheit zur Fehlerortung in langen Glasfasern vorbekannt, wobei eine kapsellose Lichtweichen-Einheit mit einem optischen Glasfaser-Informationsanschluß und mit zwei elektrischen (durchein Lichtsende-und ein -empfangs-Halbleiterbauelement gebildete) Informationsanschlüsse beschrieben sind. Die dort beschriebene Lichtweichen-Einheit ist aber für ein großes Kommunikationssystem zu unhandlich und vor allem gegen Hochfrequenzschwingungen zu wenig geschützt, besonders wenn viele solche Lichtweichen-Einheiten, auf engstem Raum in einem gemeinsamen Schrank untergebracht, gleichzeitig zu betreiben wären.

Daneben gibt es eine extrem hohe Vielzahl von weiteren Literaturstellen über den technischen Hintergrund von Lichtweichen-Einheiten und optoelektronischen Kommunikationssystemen, vgl. z.B.

DE-PS 28 51 679;

-DE-OS 28 51 696;

-DE-OS 29 03 288;

-DE-OS 29 18 403;

-DE-PS 30 12 184;

-GB-OS 2 020 447;

-US 3 953 727;

-US 4 165 496;

-Appl.Opt. 20 (15.Sept.1981) No. 18, S. 3128 bis 3135, vor allem Fig. 1, 5 und 9,

-Siemens, Forsch. u. Entw.-Ber. 12 (1983) Nr. 5, S. 332 bis 339, vor allem Fig. 2;

-Fiber and Integr. Opt. 4(1983) No. 4, S. 339 bis 372, vor allem Fig. 2, 8, 9 und 17;

-10th European Conf. on Opt. Commun.(ECOC), Stuttgart 3.-6. Sept. 1984/Conf. Proceed. S. 262 bis 263, vor allem Fig. 2;

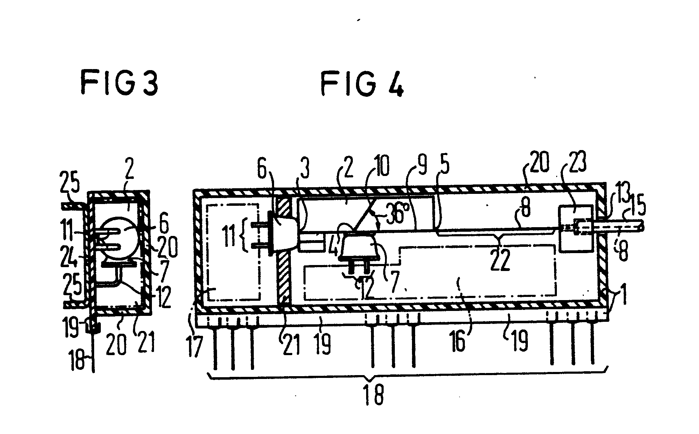

-SPIE 468 Fibre Optics '84(Sira) (1984), S. 68 bis 73, vor allem Fig. 4 und 8;

-European Conf. Opt. Commun.(ECOC), Cannes, 21.-24. Sept. 1982/Conf. Proceed. S. 305 bis 314, vor allem Fig. 4 und 7;

- Journées d' Electronique, Lausanne, 1982/Conf. Proceed. S. 89 bis 111, vor allem Fig. 1(c), 12, 14-(a,b,c) und 19;

-6th Europan Conf. on Circ. Theories and Design, Stutt gart, 6.-8. Sept. 1983/Conf. Proceed., S. 315 bis 317, vor allem Fig. 6 und 7; sowie

-U.R.S.I., Kleinheubacher Tagung 3.-7.Okt.1983/Kleinheu bacher Berichte Nr. 27, S. 13 bis 29, vor allem Fig. 1 und 5(b).

Außerdem ist für sich dem Fachmann in vielfältiger Weise bestens bekannt, Halbleiterbaukörper als Lichtsender (z.B. IRED-Dioden) oder als Lichtempfänger (z.B. Photodioden) zu verwenden. Es ist außerdem durch viele Literaturstellen vorbekannt, daß die Enden von Glasfaser-Lichtleitungen langzeitstabil sehr genau auf die optisch aktiven Stellen solcher Halbleiterbaukörper zu richten sind -oft sogar mit extrem engen Toleranzen von ± wenigen μm, manchmal von sogar ± 0,1 μm -, um dort gute optische Koppelungen zu erreichen, vgl. z.B. die

-Europ. Patentanmeldung 137 485.

Die Aufgabe der Erfindung ist, eine für die Multiplex-Demultiplex-Anwendung in vielen solchen Kommunikationssystemen möglichst vorteilhafte aufwandsarme, kompakte, leicht handhabbare Lösung zu bieten, welche nämlich

-mindestens zwei rein elektrische Informationsanschlüsse aufweist, welche gestatten, die Lichtweichen-Einheit über elektrische Ströme als Informationsträger, z.B. mittels Koaxialkabeln, mit einer Teilnehmerstation zu verbinden;

-wenig feinmechanischen und optischen Aufwand, auch hinsichtlich Glasfasersteckern und hinsichtlich Justierungen z.B. von Glasfaser-Lichtleitungen usw., erfordert;

-besonders wenig Aufwand zur Herstellung der Lichtweichen-Einheit selber erfordert;

-eine Verringerung der Gefahren hinsichtlich der Langzeitstabilität, besonders der insofern oft heiklen optischen Steckverbindungen gestattet;

-aus dem Block hervorstehende, stoßempfindliche, schwer justierbare und platzaufwendige Glasfaserbereiche -sogenannte Pigtails -vermeidet; und trotzdem

-mittels einer Kapsel auch bei später mäßig sorgfältigem Umgang einen guten Schutz gegen Berührung der berührungsempfindlichen Teile zu bieten,

-eine gute optische Kopplung an allen Lichtanschlüssen des Blockes gestattet;

-eine gute Abschirmung der Teile im Kapselinneren gegen äußere elektromagnetische oder optische Störungen bietet; sowie

-eine gute Abschirmung der Umgebung der Kapsel gegen die elektromagnetischen und optischen Schwingungen in der Kapsel bietet.

Diese Aufgabe wird durch die im Patentanspruch 1 genannten Maßnahmen gelöst.

Bei der Erfindung werden mindestens zwei der Lichtanschlüsse als -bevorzugt möglichst reflexionsarme -langzeitstabil optisch gut angekoppelte, leicht justierbare und leicht handhabbare optoelektronische Lichtanschlüsse im Inneren der abschirmenden Kapsel ausgebildet, wobei die optisch relevanten Stellen der Halbleiterbaukörper -z.B. eines IRED-Diodengehäuses und eines Phototransistorgehäuses -z.B. möglichst spaltfrei unmittelbar die betreffenden Enden der in den Block eingebetteten Glasfasern berühren können, und wobei -zur Verbesserung der gegenseitigen optischen Entkopplung des zweiten und dritten Lichtund Informationsanschlusses -am zweiten Lichtanschluß noch ein den zweiten Lichtwellenlängenbereich dämpfendes/sperrendes Lichtwellenlängenfilter zwischen dem Block und dem Lichtempfangs-Halbleiterkörper eingefügt werden kann. Auch durch die starke Verringerung der Anzahl der feinmechanisch heiklen optischen Informationsanschlüsse ist bei der Erfindung die Gefahr für die Qualität der optischen Kopplungen deutlich verringert.

Für die langzeitstabile Befestigung der Halbleiterbaukörper am Block gibt es etliche Möglichkeiten. Z.B. kann man zuerst den Block für sich in der Kapsel befestigen sowie in der Kapsel verschiebbare, justierfähige Sockel, an welchen jeweils der betreffende Halbleiterbaukörper angebracht ist, anbringen, wonach die Halbleiterbaukörper justiert und, an den Block gedrückt, endgültig befestigt werden, z.B. durch Arretieren des justierten Sockels. Man kann jedoch -zusätzlich zu solchen Sockeln oder anstelle solcher Sockel -den betreffenden Halbleiterbaukörper nach seiner Justierung, z.B. luftspaltfrei, am Block ankleben bzw. ankitten, statt ihn nur anzudrücken. Dann ist die Lichtweichen-Einheit besonders robust gegen Stöße und Vibrationen gesichert, also hinsichtlich der Güte ihrer optischen Kopplungen besonders langzeitstabil gesichert.

Die in den Unteransprüchen angegebenen zusätzlichen Maßnahmen gestatten, zusätzliche Vorteile zu erreichen. So gestatten z.B. die Maßnahmen gemäß Patentanspruch

2, die Halbleiterbaukörper mit extrem wenig Aufwand zu befestigen;

3, die optische Kopplung innerhalb der Kapsel zwischen dem Lichtsende-und dem Lichtempfangs-Halbleiterbaukörper weiter zu verringern;

4, besonders wenig Aufwand an Material, Raum und Montage-Arbeitszeit, vor allem für das Einsetzen der Halbleiterkörper in Gehäuse, zu benötigen;

5, die Lichtweichen-Einheit sehr einfach und besonders leicht zu montieren und zu reparieren, also aufwandsarm und für Massenfertigung geeignet zu gestalten, im allgemeinen auf hermetische Dichtheit der Kapsel verzichten zu können - (besonders dann, wenn alle Halbleiterbaukörper für sich in eigenen Gehäusen gekapselt sind), und zusätzlich eine Schaltung, die abgeschirmt ist gegen Hochfrequenzschwingungswirkungen, zu bieten, welche bei Bedarf, bei möglichst kurzen Hochfrequenzleitungen, z.B. eine Vorverstärkung der Signale des Lichtsende-Halbleiterbaukörpers und/oder eine Nachverstärkung der Signale des Lichtempfangs-Halbleiterbaukörpers gestattet, sowie raumsparend die Lichtweichen-Einheit gut von allen Seiten kühlbar kapseln und in einfacher Weise sehr steif auf einer Lochplatte befestigen zu können;

6, die Schaltung sowohl zur -sogar kräftigen -Vorverstärkung als auch zur -sogar kräftigen - Nachverstärkung der Signale der Halbleiterbaukörper zu verwenden;

7, die für sich sehr steife, besonders gut kühlbare Kapsel single-in-line, gemäß der

-E-A 48 938 (= VPA 80 P 6147)

auf einer Lochplatte so zu befestigen, daß dadurch auch die Lochplatte versteift wird;

8, eine unbedachte Beschädigung der nach außen gehenden, besonders leicht justierbaren Außenglasfaser weitgehend vermeiden zu können;

9, den Hohlkörper der rundum -zur Abschirmung von Hochfrequenzschwingungen -leicht erdbaren Kapsel besonders einfach und aufwandsarm herzustellen;

10,durch Wahl eines ganz besonders leicht herstellbaren, leicht handhabbaren und besonders störungsarmen Blokkes, diesen besonders geeigneten Block besonders aufwandsarm am Deckel der Kapsel befestigen zu können; und

11,die Kühlung und damit die Betriebssicherheit zu verbessern.

Die Lichtweichen-Einheit ist also zwar durchlässig für das Licht, das über die Glasfaser geleitet wird. Aber auch im übrigen muß bei der Erfindung die Kapsel nicht völlig lichtdicht sein; es genügt, wenn sie so weitgehend lichtdicht ist, daß der Betrieb der Lichtweichen-Einheit nicht mehr durch von außen kommendes Fremdlicht gestört wird -eine solche Kapsel kann man dann als de facto lichtdicht hinsichtlich störender Lichteinflüsse betrachten.

Außerdem sind, streng genommen, sowohl Lichtwellen als auch Hochfrequenzschwingungen bzw. Radiowellen jeweils "elektromagnetische" Schwingungen. Die Kapsel soll nicht nur Lichtwellen, sondern also auch kapazitiv-elektrisch, induktiv-magnetisch und/oder rein als elektromagnetische Strahlung, also elektromagnetisch im eigentlichen Sinne des Wortes wirkende Hochfrequenzschwingungen zumindest weitgehend von den Halbleiterbaukörpern und von deren elektrischen Zuleitungen innerhalb der Kapsel abschirmen.

Die Erfindung und ihre Weiterbildungen werden zur noch besseren Veranschaulichung anhand der in den Figuren gezeigten Beispiele für ein öffentliches optoelektronisches Vermittlungssystem weiter erläutert. Hierbei zeigen die Figur

1 ein Beispiel, bei welchem zwei Halbleiterbaukörper an den Block geklebt sind, und

2 ein Beispiel, bei welchem zwei Halbleiterbaukörper jeweils mittels eines justierfähigen Sockels an den Block angedrückt werden, sowie

3 einen Querschnitt und

4 einen Längschnitt durch ein Beispiel einer weitgehend lichtdicht gekapselten Lichtweichen-Einheit, wobei hier die Kapsel mindestens drei Informationsanschlüsse aufweist und einen massiven, z.B. im wesentlichen aus Quarzglas bestehenden Block 2 umschließt. Weil nackte Halbleiterkörper extrem dünn im Vergleich zum Block sind, sind in den Figuren zur besseren Demonstration nur Halbleiterbaukörper gezeigt, welche zusätzlich ein eigenes abschirmendes Gehäuse aufweisen.

Die Figuren zeigen also Beispiele einer für ein optoelektronisches Kommunikationssystem dienenden, lichtdicht gekapselten Lichtweichen-Einheit, deren Kapsel 1 jeweils drei Informationsanschlüsse 11, 12, 13 aufweist. Die Kapseln 1 umschließen einen massiven, z.B. im wesentlichen aus Glas bestehenden, Block 2, welcher seinerseits drei Lichtanschlüsse 3, 4, 5 aufweist. Die Lichtanschlüsse 3, 4, 5 sind jeweils mit einem der Informationbsanschlüsse 11, 12, 13 verbunden.

Wie bereits erwähnt, ist die Kapsel, streng genommen, nicht exakt lichtdicht, sondern sehr weitgehend lichtdicht, nämlich so lichtdicht, daß der Betrieb der Lichtweichen-Einheit nicht mehr durch von außen kommendes Licht gestört ist. Die Kapsel 1 weist nämlich z.B. einen ersten Informationsanschluß 13 auf, welcher offensichtlich durch ein noch relativ großes Loch 13 der Wand der Kapsel 1 gebildet wird, wobei durch dieses Loch 13 eine vergleichs weise dünne Außenglasfaser 8 hindurchgesteckt ist. Es kommt also noch Licht in die Kapsel 1 -nämlich sowohl über die Außenglasfaser 8 -als evtl. auch geringfügig aus der Umgebung über den Spalt zwischen dieser Außenglasfaser 8 und dem Rand des Loches 13.

Zwischen den Lichtanschlüssen 3, 4, 5 sind in den gezeigten Block 2 verzweigte Glasfasern 9 als Lichtleitungen 9 eingekittet, wobei bei diesen Beispielen der zweite und der dritte Lichtanschluß 3, 4 jeweils durch ein stumpfes Glasfaserende 3, 4 gebildet werden, welches seinerseits, z.B. wegen gemeinsamer Bearbeitung durch Schleifen und Polieren, in derselben Ebene wie die jeweils dort angrenzende Block-Oberfläche liegt.

Ein Lichtwellenlängenfilter 10 ist in eine der Glasfasern 9 des Blockes 2 so eingefügt, daß der Block 2 eine Lichtweiche darstellt, bei welcher im Betrieb der erste Lichtanschluß 5 bidirektional, und der zweite und der dritte Lichtanschluß 4, 3 unidirektional betrieben wird. Das dem ersten Lichtanschluß 5 über den ersten Informationsanschluß 13 zugeleitete Licht eines ersten Lichtwellenlängenbereiches wird im wesentlichen nur zum zweiten Lichtanschluß 4 weitergeleitet, und das dem dritten Lichtanschluß 3 zugeleitete Licht eines sich vom ersten unterscheidenenden zweiten Lichtwellenlängenbereiches im wesentlichen nur zum ersten Lichtanschluß 5 und von dort weiter über den ersten Informationsanschluß 13 aus der Kapsel 1 hinaus weitergeleitet.

Innerhalb ihrer lichtdichten, zur Abschirmunrng von elektromagnetischen Störungen bevorzugt aus Metall bestehenden, Kapsel 1 ist, unter Vermeidung von rein optischen Informationsanschlüssen 11, 12, am zweiten Lichtanschluß 4 ein optoelektronischer Lichtempfangs-Halbleiterbaukörper 7 zur Umwandlung von auf Licht modulierten Informationen in auf elektrische Ströme modulierte Information, sowie am dritten Lichtanschluß 3 ein optoelektronischer Lichtsende-Halbleiterbaukörper 6 zur Umwandlung von auf elektrischen Strömen modulierten Informationen in auf Licht modulierte Informationen befestigt, und zwar zur Optimierung der optischen Kopplung z.B.

jeweils möglichst unmittelbar - nämlich ohne Einfügung einer Glasfaser oder eines Luftspaltes zwischen den Block 2 und den beiden Halbleiterbaukörpern 6,7 -befestigt.

Beide Halbleiterbaukörper 6, 7 können also auch nackt, statt, wie in den Figuren gezeigt, in eigenen zusätzlichen Gehäusen untergebracht, am Block 2 befestigt sein. Daher stellen die mit den beiden Halbleiterbaukörpern 6, 7 verbundenen Informationsanschlüsse 11, 12 jeweils elektrische Anschlüsse, aber der erste, mit dem ersten Lichtanschluß 5 verbundene Informationsanschluß 13 einen optischen Anschluß 13 dar. Auf diese Weise sind die beiden gezeigten Beispiele jeweils auch als Schnittstelle zwischen einerseits einer außerhalb von der Kapsel 1 angebrachten Glasfaser-Lichtleitung, welche an den ersten Informationsanschluß 13 angeschlossen und bidirektional betrieben ist, und andererseits elektronischen Schaltungsanordnungen, welche an die anderen Informationsanschlüsse 11, 12 angeschlossen sind, geeignet. Durch den erfindungsgemäßen Aufbau sind diese Beispiele sehr kompakt, stoßgesichert und wenig empfindlich gegen von außen kommende elektrische und magnetische bzw. elektromagnetische sowie optische Störungen, und auch die im Inneren der Kapsel auftretenden elektromagnetischen und optischen Schwingungen werden nach außen hin durch die Kapsel abgeschirmt.

Bei dem in Fig. 1 gezeigten Beispiel sind sowohl der Lichtsende-Halbleiterkörper 6 als auch der Lichtempfangs-Halbleiterkörper 7 an den Block 2 angeklebt, wodurch die Lichtweichen-Einheit besonders langzeitstabil sehr unemp findlich gegen Stöße und Vibrationen ist.

Bei dem in Fig. 2 gezeigten Beispiel sind jedoch die beiden Halbleiterbaukörper 6, 7 an verschiebbaren, also justierbaren Sockeln 14 befestigt, z.B. dort angeklemmt und danach zusätzlich dort angeklebt, und erst danach sind durch Verschieben der beiden Sockel 14 die optischen Kopplungen zu den Glasfaserenden 3, 4 optimiert und die Sokkeln 14 in der optimalen Lage arretiert, z.B. angeklebt.

Häufig genügt es, wie bereits erwähnt, wenn zumindest einer der beiden Halbleiterbaukörper 6, 7 für sich innerhalb der Schutzkapsel 1 kein eigenes zusätzliches Gehäuse als Abschirmgehäuse aufweist, welches den Halbleiterbaukörper 6, 7 gegen die Hochfrequenzschwingungen von modulierten Strömen abschirmt. Dadurch kann man den Aufwand für die Lichtweichen-Einheit weiter verringern -vor allem kann man dadurch auch die Kapsel 1 ganz besonders klein machen, also auch den Raumaufwand und die Leitungslängen in der Kapsel und damit die Störanfälligkeit bei elektrischen Höchstfrequenzen verringen -beides ist besonders bei sehr großen Vermittlungssystemen, welche oft sehr viele Tausend solcher Lichtweichen-Einheiten dicht in Schränke gepackt enthalten können, sehr wichtig.

In einem Kommunikationssystem können daher die gezeigten Lichtweichen-Einheiten als Multiplexer-Demultiplexer-Baustein, nämlich vor allem als sog. WDM, verwendet werden.

Der Block 2 kann an sich im übrigen beliebig aufgebaut sein. Er kann z.B. im wesentlichen aus Quarz, Glas und/oder Silizium bestehen, vgl. z.B. die in den oben angegebenen Literaturstellen teilweise sehr genau beschriebenen Herstellungsverfahren, wobei die Glasfasern z.B. in lichtdämpfende Kitte oder Rillen eingebettet sein können. Das Lichtwellenlängenfilter 10 besteht z.B. in für sich bekann ter Weise aus einem dielektrischen Vielschicht-Interferenzfilter und hat die Funktion eines wellenlängenselektiven Teilerspiegels.

Bei allen Beispielen kann an sich der Block 2 auch erheblich mehr als nur zwei, sondern z.B. auch sechs, unidirektional betriebene Lichtschlüsse aufweisen, damit also die Kapsel 1 erheblich mehr als nur zwei elektrische Informationsanschlüsse aufweisen; dann kann auch besonders sein erster Lichtanschluß -aber auch noch weitere Lichtanschlüsse -Licht von erheblich mehr von nur zwei Lichtwellenlängenbereichen aufweisen. Der Block 2 kann also auch z.B. gemäß

-DE-OS 30 12 184, Fig. 4 oder 5, oder

-Appl.Opt. 20 (15.Sept.1981) No. 18, S. 3128 bis 3135, Fig. 9

aufgebaut sein.

Die Erfindung benötigt also keinen Block 2 mit aus dem Block hervorstehenden Pigtails oder mit optischen Steckern an den Lichtanschlüssen 3, 4, was ebenfalls die ganz besonders kleinen Abmessungen ermöglicht. Überdies ist ein mit Pigtails ausgestatteter Block 2 beim Justieren der Halbleiterbaukörper 6, 7 in einer eng dimensionierten Kapsel 1 schwierig zu handhaben, da solche Pigtails oft stark bruchgefährdet sind. In manchen Anwendungen in einem (z.B.ISDN-)Vermittlungssystem wird man allerdings einen Pigtail, oft sogar ein längerers Stück ummantelter, zugentlasteter, weit aus der Kapsel 1 herausragender Glasfaser für den ersten Lichtanschluß und ersten Informationsanschluß akzeptieren. Aber bereits durch die Verminderung der Anzahl der optischen Stecker der Kapsel, z.B. von drei auf nur noch einen einzigen optischen Stecker, werden auch die Verluste bzw. Dämpfungen des Lichtes in diesen Steckern vermieden.

Wegen der kompakten Aufbauweise der Kapsel mit besonders kleinen Abmessungen sind, wie bereits angedeutet, auch die elektrischen Leitungslängen entsprechend sehr kurz dimensionierbar, also auch für sehr hohe Frequenzen der elektrischen Ströme besonders gut geeignet.

Bei den in den Figuren 3 und 4 in zwei zueinander senkrechten Schnitten gezeigten Beispiel weist der Block 2 ebenfalls drei Lichtanschlüsse 3, 4, 5 auf, welche jeweils mit einem der Informationsanschlüsse 11, 12, 13 optisch verbunden sind. Zwischen den Lichtanschlüssen 3, 4, 5 ist hier in den Block 2 nur eine einzige, gestreckte Multimode-Glasfaser 9 von dem ersten Lichtanschluß 5 bis zu dem -im Gegensatz zu Fig. 1 und 2 -hier mit dem Lichtsende -Halbleiterbaukörper 6 optisch gekoppelten dritten Lichtanschluß 3 des Blockes 2 eingebettet, z.B. eingekittet. Nur der dritte Lichtanschluß 3 des Blokkes 2 wird durch ein ebenes Glasfaserende 3 gebildet, welches, wegen gemeinsamer Bearbeitung durch Schleifen und Polieren, zumindest angenähert in derselben Ebene wie nahe Bereiche der dortigen Blockoberfläche liegt und welches also vom Lichtsende-Halbleiterbaukörper 6 bedeckt ist.

Am zweiten Lichtanschluß 4 wird hier -im Gegensatz zu Fig. 1 und 2 -das seitlich aus der gestreckten Glasfaser 9 bzw. 5-3 wegreflektierte, vom ersten Lichtanschluß 5 kommende Licht empfangen. Dementsprechend ist hier der Licht empfangs -Halbleiterbaukörper 7 direkt auf die dort ebene Blockoberfläche über dem Spiegel 4 der Glasfaser 9 geklebt. Der Block 2 weist auch hier zumindest an seinem zweiten und dritten Lichtanschluß 4, 3 kein freies Glasfaserende, also z.B. keine schützende starre Halterung eines hervorstehenden Glasfaserendes auf, das aus dem Block 2 hervorsteht.

Ein besonders gut selektierendes Vielschicht-Lichtwellen längenfilter 10 ist in seine Glasfaser 9 so eingefügt, daß der Block 2 eine Lichtweiche darstellt, bei welcher im Betrieb der erste Lichtanschluß 5 bidirektional und der zweite und der dritte 4, 3 unidirektional betrieben wird. Hierbei wird das dem ersten Lichtanschluß 5 über den ersten Informationsanschluß 13 zugeleitete Licht eines ersten Lichtwellenlängenbereiches wegen des hochselektiven Filters 10 im wesentlichen nur zum zweiten Lichtanschluß 4 .weitergeleitet, aber das dem dritten Lichtanschluß 3 zugeleitete Licht eines sich vom ersten unterscheidenden zweiten Lichtwellenlängenbereiches im wesentlichen nur zum ersten Lichtanschluß 5 und von dort dann weiter über den ersten Informationsanschluß 13.

Innerhalb ihrer elektrisch leitenden, elektronische Hochfrequenzschwingungen abschirmenden Kapsel 1 ist also am zweiten Lichtanschluß 4 der Lichtempfangs-Halbleiterkörper 7 zur Umwandlung von auf Licht modulierten Informationen in auf elektrische Ströme modulierte Informationen, sowie am dritten Lichtanschluß 3 der Lichtsende-Halbleiterbaukörper 6 zur Umwandlung von auf elektrischen Strömen modulierten Informationen in auf Licht modulierte Informationen befestigt, und zwar jeweils ohne Einfügung einer zusätzlichen Glasfaser zwischen dem Block 2 und den beiden Halbleiterbaukörpern 6, 7. Daher sind hier die mit den beiden Halbleiterbaukörpern 6, 7 verbundenen äußeren Informationsanschlüsse 11, 12 -also ihre Anschlußleitungen 11,12 bzw. hierzu gehörende Kontaktstifte 18 -jeweils elektrische Anschlüsse der Lichtweichen-Einheit, aber ihr erster, mit dem ersten Lichtanschluß 5 verbundener Informationsanschluß 13 ein rein optischer Anschluß.

Die Kapsel 1 besteht aus zumindest zwei Teilen, vgl. 19, 20, nämlich aus einem mehr oder weniger hohlen Hohlkörper 20 und aus einem mehr oder weniger ebenen Deckel 19. Auf der Innenseite der Kapsel 19/20 ist sehr leicht zugänglich der Block 2 mit seinen Halbleiterbaukörper 6, 7 befestigt, sowie noch mindestens eine elektrische Schaltung 16, 17, die ihrerseits z.B. aus diskreten Bauelementen und/oder aus einem oder mehreren Chips bestehen kann und die hier mit beiden Halbleiterbaukörpern 6, 7 verschaltet ist, hier nämlich 16 über 12 mit 7, sowie 17 über 11 mit 6.

Die in Fig. 3 und 4 gezeigte Lichtweichen-Einheit soll also in einen Kommunikationssystem, z.B. in einem ISDN-Vermittlungssystem, in der Nähe von weiteren Hochfrequenzschaltungen als hochfrequenzabgeschirmte Schnittstelle dienen, und zwar zwischen

-einerseits einer außerhalb von der Kapsel 19/20 ange brachten Außenglasfaser 8, welche an den ersten Informa tionsanschluß 13 angeschlossen und bidirektional betrie ben wird, und

-andererseits elektronischen Hochfrequenz-Schaltungsan ordnungen, welche an die anderen Informationsanschlüsse 11, 12 angeschlossen sind.

Diese Lichtweichen-Einheit mit der, hier aus einem weitgehend ebenen Deckel 19 und hutförmigen Hohlkörper 20 bestehenden, Kapsel 1 bietet alle oben zum Patentanspruch 1 angegebenen Vorteile, vor allem also auch eine sehr aufwandsarme leichte Herstellbarkeit bei Massenfertigung, sowie die -wegen der besonders leicht zugänglichen Anordnung aller auf der Deckelinnenseite angebrachten Teile leichte Reparierbarkeit und Überprüfbarkeit. Die sehr steife, raumsparende, im Regelfall nicht einmal hermetisch dicht angebrachte Kapsel 1 stellt auch einen Berührungsschutz sowie eine optische und elektrische Abschirmung dar. Überdies ist sie sehr leicht von außen kühlbar.

Bei dem gezeigten Beispiel besteht, nur - schematisch gezeigt, die auf der Deckelinnenseite befestigte Schaltung 16, 17 ihrerseits auch aus zwei Teilen, nämlich

-aus der an sich beliebig aufgebauten, dem Lichtsende-Halbleiterbaukörper 6 vorgeschalteten Sendeeinheit 17 und

-aus der ebenfalls an sich beliebig aufgebauten, dem Lichtempfangs-Halbleiterbaukörper 7 nachgeschalteten Empfangseinheit 16.

In der Kapsel 19/20 wird die Sendeeinheit 17 und die Empfangseinheit 16 durch eine, elektrische Hochfrequenzschwingungen abschirmende Abschirmwand 21 zumindest weitgehend räumlich getrennt, wobei die Abschirmwand 21 hier in den Hohlkörper 20 eingefügt, z.B. hineingeklemmt oder hineingelötet ist.

Der Deckel 19 wird zur Deckelinnenseite hin z.B. durch einen aus einem Isolator gebildeten Träger 19 gebildet, welcher dann unmittelbar auf der Deckelinnenseite den Bloch 2 mit seinen Halbleiterbaukörpern 6, 7 sowie die Schaltung 16, 17 und zugehörende Leitungsbahnen tragen kann. An der einen Kante des Trägers 19 sind single-in-line eine Vielzahl von Kontaktstiften 18 befestigt, welche über, ebenfalls auf dem Träger 19 angebrachte, Leitungsbahnen mit den entsprechenden Anschlüssen der Schaltung 16, 17 verschaltet sind. Auf der anderen Seite des Trägers 19 ist ein steifes Kühlblech 24/25 mit Winkeln 25 angeklebt, welches seinerseits, abgesehen von den Kontaktstiften 18, zumindest weitgehend den Träger 19 bedeckt und zur Verbesserung der Kühlung und Steifigkeit des Deckels 19 und der Kapsel 1 dient. Dieser Deckel 19 ist also nach dem Vorbild der

-E-A 48 938

aufgebaut, wodurch er zusätzlich die Lochplatte, in die seine Kontaktstifte 18 gelötet sind, versteifen kann. Diese Lochplatte kann sich dann also bei Hitze ebenfalls nicht mehr so leicht verziehen.

Besonders leicht ist der Hohlkörper 20 dann herstellbar, wenn er nicht aus Metall, sondern zumindest weitgehend aus metallisiertem Kunststoff hergestellt wird. Die Metallisierung kann man hierbei z.B. durch Mitumspritzen eines hutförmig vorgeformten Metalldrahtnetzes erreichen. Der Hohlkörper 20 kann auch mittels einer Metallfolie hergestellt werden, die eine in den Kunstoff-Hohlkörper 20 eingesetzte oder umgespritzte Wanne bildet. Es ist aber auch ein dünner Metallhohlkörper 20 einsetzbar.

Der Hohlkörper 20 kann z.B. auf den Deckel 19 aufgeklebt oder durch Rastung mit ihm verbunden, sowie jeweils mit Erdungsanschlüssen kontaktiert werden.

Sehr einfach ist der Block 2 herstellbar und ausreichend genau justiert auf der Deckelinnenseite befestigbar, wenn er ähnlich wie hier in den Fig. 3 und 4 gezeigt aufgebaut ist, nämlich gemäß der Patentanmeldung

-P 36 03 023.6 = VPA 86 P 1035 DE,

wenn er also mehr oder weniger genau einen Quader bildet, in dessen einer Oberfläche eine Rille 3-5 angebracht ist, in der eine Glasfaser 9 eingebettet ist, wobei der Block 2 zusammen mit der Glasfaser 9 einen Spiegel 10, z.B. ein Mehrschichten-Lichtwellenfilter 10 in einem solchen Winkel -von z.B. 35° -aufweist, daß das vom ersten Lichtanschluß 5 kommende, auf den Spiegel 10 treffende Licht mit einen kleineren Einfallswinkel als 45° zum unmittelbar darüber angebrachten Lichtempfangs-Halbleiterbaukörper 7 hin gespiegelt wird. Eine solche Lichtweiche 2/6/7 hat überdies den Vorteil, daß Betriebsstörungen durch gewisse, sonst oft an der Oberfläche des Lichtempfangs-Halbleiterbaukörpers 6 auftretende Reflexionen - (Fehlanpassung) weitgehend durch jene spezielle Wahl des Einfallswinkels unterdrückt werden. Im Gegensatz zu Lichtsende-Halbleiterbaukörpern 6 muß die optisch relevante Oberfläche von Lichtempfangs-Halbleiterbaukörpern 7 im allgemeinen nicht präzise senkrecht zum dortigen Licht strahl orientiert werden, so daß bei dieser Variante der Erfindung dort kaum erhebliche Justierschwierigkeiten auftreten. Ferner hat ein solcher unter ca. 35° Einfallswinkel angebrachter Spiegel 10 noch den Vorteil, daß seine Filtercharakteristik wegen dieses Einfallswinkels besonders steile Flanken aufweist.

Wenn zusätzlich ein Interferenzfilter vor dem Lichtempfangs-Halbleiterbaukörper 7, z.B. als dünnes Plättchen, eingeschoben oder direkt auf das Fenster des Lichtempfangs-Halbleiterbaukörpers 7 aufgedampft wird, kann bei Bedarf ein evtl. auftretendes restliches optisches Nebensprechen weiter vermindert werden.

Diese Lichtweiche mit den hybridierten optoelektronischen Halbleiterbaukörpern 6, 7 ist also auf dem Deckel 19 befestigt, z.B. geklebt oder geklammert. Außerdem ist bei einem derartigen Aufbau der Lichtweiche auch die Ankopplung der bidirektional betriebenen Außenglasfaser 8 an die eingebettete Glasfaser 9 besonders leicht herstellbar und am fertig auf dem Deckel 19 leicht überprüfbar. Die eingebettete Glasfaser 9 kann sogar zusammen mit der Außenglasfaser 8 eine einzige gemeinsame Glasfaser 8-9 bilden.

Auf der Deckelinnenseite ist hier zusätzlich leicht zugänglich eine Zugentlastungseinheit 23 befestigt, an welcher die Außenglasfaser 8, genauer gesagt z.B. eine Kunststoffummantelung 15 dieser Lichtleitung 8, befestigt ist. Besonders solide ist diese Ankopplung dann, wenn man die Außenglasfaser 8 zwischen dem ersten Lichtanschluß 5 und der Zugentlastungseinheit 23 als freiliegenden Pigtail 22 gestaltet, der bevorzugt so lang ist und schwach durchhängend mittels der Zugentlastung 23 befestigt wird, daß der Pigtail 22 genügend Spielraum zum Ausleich unterschiedlicher, z.B. durch Temperaturschwankungen hervorgerufener, Längenänderungen aufweist. Wenn, wie häufig üblich, der Träger 19 einen größeren Wärmeausdehnungs-Koeffizienten als die Außenglasfaser 8 aufweist, ist es daher günstig, die Außwenglasfaser 8 an der Zugentlastungseinheit 23 bei der höchstzulässigen Betriebstemperatur, oder sogar bei noch höherer Temperatur, zu befestigen, weil dann der Pigtail 22 nach der Abkühlung wie erwünscht leicht durchhängt. Wenn dieser Koeffizient des Trägers 19 aber kleiner als der der Außenglasfaser 8 ist, sollte man diese Außenglasfaser 8 bei möglichst tiefer Temperatur an der Zugentlastungseinheit 23 befestigen.

Zur Abstützung, auch zur Zugentlastung, des Pigtails kann auf dem Deckel 19 die Zugentlastungseinheit 23 übrigens z. B. auch in solcher Weise hybridiert angebracht werden, daß an der Zugentlastungseinheit 23 ein Hüllschlauch 15 befestigt wird, so daß die Außenglasfaser 8, sogar mit Coating, zunächst ohne jegliche Befestigung durch diesen Hüllschlauch 15 gesteckt wird, wonach diese Außenglasfaser 8 an dem Hüllschlauch 15 der Zugentlastungseinheit 23 (und evtl. bei Bedarf noch am ersten Lichtanschluß 5) befestigt, z.B. dort elastisch angeklebt wird.

Zur Verbesserung der Kühlung, besonders der Kühlung eines durch eine GaAs-Laserdiode 6 gebildeten Lichtsende-Halbleiterbaukörpers 6, kann man zusätzlich gut wärmeleitende Wärmeableitkörper einfügen, also z.B. zwischen dem Baukörper 6 einerseitss und dem Deckel 19 und/oder Hohlkörper 20 andererseits, um die von diesem Baukörper 6 erzeugte hohe Verlustwärme besonders rasch über den Wärmeableitkörper und über die Außenoberfläche der Kapsel 19/20 an die Umgebung (Luft) abzuleiten. Ein solcher Wärmeableitkörper kann z.B. als metallische Feder gemäß den deutschen Patentanmeldungen

-P 34 29 281.0 = VPA 84 P 1584,

-P 35 31 136.3 = VPA 85 P 1588, sowie

-P 35 31 746.9 = VPA 85 P 1605

aufgebaut sein. Zur Wärmeableitung eignet sich übrigens auch die Abschirmwand 21, wenn sie gut wärmeleitend, also z.B. aus Metall hergestellt, ist.

**Ansprüche**

1. Für ein optoelektronisches Kommunikationssystem dienende, zumindest weitgehend lichtdicht gekapselte(1) Lichtweichen(2)-Einheit (1, 2), wobei

-ihre Kapsel(1) mindestens drei Informationsanschlüsse (11, 12, 13) aufweist, und

-ihre Kapsel(1) einen massiven, z.B. im wesentlichen aus Glas(2) bestehenden, Block(2) umschließt, welcher(2) seinerseits

* mindestens drei Lichtanschlüsse(3, 4, 5) aufweist, welche jeweils mit einem der Informationsanschlüsse (11, 12, 13) verbunden sind,

* zwischen seinen Lichtanschlüssen(3, 4, 5), in den Block(2) eingebettet -nämlich z.B. eingekittet, mindestens eine Glasfaser(9)-Lichtleitung aufweist,

* mindestens sein zweiter und/oder sein dritter Lichtanschluß(3, 4) durch ein ebenes Glasfaserende(3, 4) gebildet wird, welches(3, 4) seinerseits, z.B. wegen gemeinsamer Bearbeitung durch Schleifen und Polieren, zumindest angenähert in derselben Ebene wie nahe Bereiche der Block(2)-Oberfläche liegt,

* zumindest an seinem zweiten und dritten Lichtanschluß (3, 4) kein freies Glasfaserende(3, 4), also ohne schützende starre Halterung, aus dem Block-(2) hervorsteht, und

* mindestens ein Lichtwellenlängenfilter(10), welches in mindestens eine seiner, Glasfasern(9) eingefügt ist, aufweist, wodurch der Block(2) die Lichtweiche (2) darstellt, bei welcher im Betrieb

: der erste Lichtanschluß(5) bidirektional betrieben wird,

: der zweite und der dritte Lichtanschluß(4, 3) unidirektional betrieben wird,

: das dem ersten Lichtanschluß(5) über den ersten Informationsanschluß(13) zugeleitete Licht eines ersten Lichtwellenlängenbereiches im wesentlichen nur zum zweiten Lichtanschluß(4) weitergeleitet wird, und

: das dem dritten Lichtanschluß(3) zugeleitete Licht eines sich vom ersten unterscheidenden zweiten Lichtwellenlängenbereiches im wesentlichen nur zum ersten Lichtanschluß(5) und weiter über den ersten Informationsanschluß(13) weitergeleitet wird,

insbesondere für ein durch ein öffentliches ISDN-Vermittlungssystem gebildetes Kommunikationssystem, **dadurch gekennzeichnet, daß**

-innerhalb ihrer elektrisch leitenden, elektromagnetische Hochfrequenzschwingungen abschirmenden Kapsel(1)

* am zweiten Lichtanschluß(4) ein Lichtempfangs-Halbleiterbaukörper(7) zur Umwandlung von auf Licht modulierten Informationen in auf elektrische Ströme modulierte Informationen, sowie

* am dritten Lichtanschluß(3) ein Lichtsende-Halbleiterbaukörper(6) zur Umwandlung von auf elektrischen Strömen modulierten Informationen in auf Licht modulierte Informationen,

jeweils ohne Einfügung einer zusätzlichen Glasfaser zwischen dem Block(2) und den beiden Halbleiterbaukör pern(6, 7), befestigt ist,

-zumindest ihre mit den beiden Halbleiterbaukörpern(6, 7) verbundenen Informationsanschlüsse(11, 12) elektrische Anschlüsse, aber zumindest ihr erster, mit dem ersten Lichtanschluß(5) verbundener Informationsanschluß (13) ein optischer Anschluß ist, und

-sie im Kommunikationssystem, in der Nähe von weiteren Hochfrequenzschaltungen, als hochfrequenz-abgeschirmte Schnittstelle zwischen einerseits einer außerhalb von ihr angebrachten Glasfaser-Lichtleitung, welche an den ersten Informationsanschluß(13) angeschlossen und bidirektional betrieben ist, und andererseits elektronischen Hochfrequenz-Schaltungsanordnungen, welche an die anderen Informationsanschlüsse(11, 12) angeschlossen sind, dient.

2. Lichtweichen-Einheit nach Patentanspruch 1, **dadurch gekennzeichnet, daß**

-ihr Lichtsende-Halbleiterbaukörper(6) und ihr Lichtempfangs-Halbleiterbaukörper(7) an ihren Block(1) jeweils linsenfrei und luftspaltfrei angeklebt/angekittet sind.

3. Lichtweichen-Einheit nach Patentanspruch 1 oder 2, **dadurch gekennzeichnet, daß**

-zwischen dem Lichtempfangs-Halbleiterbaukörper-(7) und dem zweiten Lichtanschluß(4) ein den zweiten Lichtwellenlängenbereich sperrendes/dämpfendes zusätzliches Lichtwellenlängenfilter eingefügt ist.

4. Lichtweichen-Einheit nach Patentanspruch 1, 2 oder 3, **dadurch gekennzeichnet**, daß

-zumindest einer ihrer Halbleiterbaukörper(6, 7) für sich innerhalb der Kapsel(1) kein eigenes zusätzliches Abschirmgehäuse aufweist, welches dessen Halbleiter und elektrischen Anschlüsse gegen die Hochfrequenzschwingungen der modulierten Ströme abschirmt.

5. Lichtweichen-Einheit nach einem der vorhergehenden Patentansprüche,

**dadurch gekennzeichnet**, daß

-die Kapsel(1, 19/20) aus zumindest zwei Teilen(19, 20), nämlich aus einem mehr oder weniger hohlen Hohlkörper (20) und aus einem mehr oder weniger ebenen Deckel(19) gebildet ist, und

-auf der Deckelinnenseite, nämlich am Deckel(19) auf der Innenseite der Kapsel(1, 19/20), der Block-(2) mit seinen Halbleiterbaukörpern(6, 7), sowie mindestens eine elektrische Schaltung(16, 17) z.B. aus diskreten Bauelementen und/oder aus einem oder mehreren Chips, befestigt ist, welche(16, 17) mit zumindest einem der beiden Halbleiterbaukörper(16 über 12 mit 7, sowie 17 über 11 mit 6) verschaltet ist.

6. Lichtweichen-Einheit nach Patentanspruch 5, **dadurch gekennzeichnet**, daß

-die auf der Deckelinnenseite befestigte Schaltung-(16, 17) zumindest aus einer dem Lichtsende-Halbleiterbaukörper(6) vorgeschalteten Sendeeinheit-(17) und aus einer dem Lichtempfangs-Halbleiterbaukörper(7) nachgeschalteten Empfangseinheit-(16) besteht, und

-in der Kapsel(1, 19/20) die Sendeeinheit(17) und die Empfangseinheit(16) durch eine, elektrische Hochfrequenzwellen abschirmende Abschirmwand-(21), die eine Öffnung für die optoelektronische Verbindung zwischen der Sendeeinheit(17) und dem dritten Lichtanschluß(3) des Blockes 2 aufweist, zumindest weitgehend räumlich getrennt sind.

7. Lichtweichen-Einheit nach Patentanspruch 5 oder 6, **dadurch gekennzeichnet**, daß

-der Deckel(19, 24/25) zur Deckelinnenseite hin durch einen aus einem Isolator gebildeten Träger-(19) gebildet wird, welcher(19)

* auf der Deckelinnenseite den Block(2) mit seinen Halbleiterbaukörpern(6, 7) sowie die Schaltung(16, 17) und zugehörende Leitungsbahnen trägt,

* an seiner einen Kante single-in-line eine Vielzahl von Kontaktstiften(18) trägt, welche(18) über Leitungsbahnen mit der Schaltung(16, 17) verschaltet sind, und

* auf seiner anderen Seite, der Deckelaußenseite, mit einem metallischen Blech(24/25) beklebt ist, welches (24/25) seinerseits, abgesehen von den Kontaktstiften (18), zumindest weitgehend den Träger(19) bedeckt.

8. Lichtweichen-Einheit nach einem der Patentansprüche 5 bis 7,

**dadurch gekennzeichnet**, daß

-auf der Deckelinnenseite eine Zugentlastungseinheit(23) befestigt ist, an welcher-(23) die Außenglasfaser(8) befestigt ist.

9. Lichtweichen-Einheit nach einem der Patentansprüche 5 bis 8,

**dadurch gekennzeichnet**, daß

-der Hohlkörper(20) zumindest weitgehend aus metallisiertem Kunststoff besteht.

10. Lichtweichen-Einheit nach einem der Patentansprüche 5 bis 9,

**dadurch gekennzeichnet**, daß

-der Block(2) einen Quader bildet, in dessen einer Oberfläche eine Rille(3-5) angebracht ist, in der eine Glasfaser(9) eingebettet ist,

-der Block(2) zusammen mit der Glasfaser(9) einen Spiegel(10) mit einem Lichtwellenlängenfilter(10) in einem solchen Winkel(z.B. 35°) aufweist, daß das vom ersten Lichtanschluß(5) auf den Spiegel(10, bei 4) treffende Licht mit einen kleineren Einfallswinkel(35°) als 45° am Spiegel(4) zum zweiten Lichtanschluß(4) hin gespiegelt wird, und

-unmittelbar über dem Spiegel(4) der Glasfaser(9) auf dem Block(2) der Lichtempfangs-Halbleiterbaukörper(7) befestigt ist.

11. Lichtweichen-Einheit nach einem der vorhergehenden Patentansprüche,

**dadurch gekennzeichnet**, daß

-zwischen dem Lichtsende-Halbleiterbaukörper(6) und der Kapsel(19/20) ein metallischer Wärmeableitkörper zur Wärmeableitung von diesem Halbleiterkörper(6) zur Kapseloberfläche angebracht ist.

10

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 851 625 (SIEMENS) <br> * Seite 15, Zeile 25 - Seite 18, Zeile 30; Abbildung 2 * <br><br> --- | 1-3,5 | G 02 B 6/34 <br> H 01 L 31/02 |
| A | EP-A-0 153 722 (OKI ELECTRIC INDUSTRY CO.) <br> * Seite 9, Zeile 8 - Seite 10, Zeile 27; Seite 1, Zeilen 22-27; Abbildungen 1,4a,4b * <br><br> --- | 1,3,5-7,9,11 | |
| A | FR-A-2 552 236 (COMPAGNIE GENERALE D'ELECTRICITE) <br> * Anspruch 1; Seite 7, Zeilen 6-8; Abbildung 17 * <br><br> --- | 1 | |
| A. | EP-A-0 012 190 (SIEMENS) <br> * Seite 3, Zeile 12 - Seite 4, Zeile 19; Abbildungen 1,2 * <br><br> --- | 1 | RECHERCHIERTE SACHGEBIETE (Int. Cl.4) |
| A | EP-A-0 003 575 (CSELT) <br> * Seite 6, Zeile 13 - Seite 7, Zeile 4; Abbildung 2 * <br><br> --- | 1 | G 02 B <br> H 04 J <br> H 04 B <br> H 01 L <br> H 01 S |
| A | FR-A-2 549 243 (COMPAGNIE LYONNAISE DE TRANSMISSIONS OPTIQUES) <br> * Seite 4, Zeilen 9-33; Abbildungen 2,8 * <br><br> ---     -/- | 1,2 | |

Der vorliegende Recherchenbericht wurde für alle Patentansprüche erstellt.

| Recherchenort <br> DEN HAAG | Abschlußdatum der Recherche <br> 28-10-1986 | Prüfer <br> GALLO G. |
|---|---|---|

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03.82

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | JOURNAL OF LIGHTWAVE TECHNOLOGY, vol. LT-2, no. 5, Oktober 1984, Seiten 675-681, IEEE, New York, US; A. REICHELT et al.: "Wavelength-division multi demultiplexers for two-channel single-mode transmission systems" * Insgesamt * | 1 | |
| | --- | | |
| A | EP-A-0 100 086 (INTERNATIONAL STANDARD ELECTRIC) * Ansprüche; Figuren 1-11 * | 5-11 | |
| | --- | | |
| A | GB-A-2 052 140 (PHILIPS) * Zusammenfassung * | 5 | |
| | --- | | |
| A | EP-A-0 111 264 (SIEMENS) * Ansprüche * | 5-11 | RECHERCHIERTE SACHGEBIETE (Int. Cl.4) |
| | --- | | |
| D,A | EP-A-0 048 938 (SIEMENS) * Ansprüche * | 5-11 | |
| | --- | | |
| A | EP-A-0 037 057 (SIEMENS) * Seite 6, Zeile 32 - Seite 7, Zeile 14; Abbildung 2 * & DE-A-3 012 184 (Kat. D) | 1 | |
| | ----- | | |

Der vorliegende Recherchenbericht wurde für alle Patentansprüche erstellt.

| Recherchenort DEN HAAG | Abschlußdatum der Recherche 28-10-1986 | Prüfer GALLO G. |
|---|---|---|